# EUROPÄISCHE PATENTSCHRIFT

(11) **EP 0 485 790 B1**
(45) Veröffentlichungstag und Bekanntmachung des Hinweises auf die Patenterteilung: **30.08.1995**
(21) Anmeldenummer: 91118290.5
(22) Anmeldetag: 26.10.1991
(51) Int. Cl.: H05K 3/00, B23D 45/10, B27B 33/20

(54) **Vorrichtung zum Trennen und Besäumen von Leiterplatten**
Device for separating and edging printed circuit boards
Dispositif de séparation et de bordure de cartes à circuits imprimés

(30) Priorität: 10.11.1990 DE 4035792
(43) Veröffentlichungstag der Anmeldung: 20.05.1992
(73) Patentinhaber: Löhr & Herrmann GmbH, D-75242 Neuhausen/E. (DE)
(72) Erfinder: Löhr, Hans-Günter, Dr.-Ing., W-7135 Wiernsheim (DE); Herrmann, Gunter, Dr.-Ing., W-7260 Calw (DE); Mozzi, Josef, W-7531 Neuhausen-Hamberg (DE)
(74) Vertreter: Hubbuch, Helmut, Dipl.-Ing

(56) Entgegenhaltungen:
- EP-A- 0 315 739
- DE-A- 2 159 427
- GB-A- 2 050 895

## Beschreibung

Die Erfindung betrifft eine Vorrichtung zum Trennen und Besäumen von Leiterplatten bzw. Leiterplattennutzen, insbesondere von dünnen Leiterplatten sowie mehrlagigen Leiterplatten.

Solche Leiterplatten werden hergestellt, indem auf eine Außenlage nacheinander die Kunstharz-Zwischenlagen und Leiterplatten-Innenlagen im Wechsel aufgeschichtet werden (Multilayer), wobei die Position der verschiedenen Lagen mittels geeigneter Positionshilfen, wie z.B. Fangstiften, bestimmt wird. Anschließend werden die Leiterplatten unter Einwirkung von Hitze und Druck verpreßt. Dabei wird das Kunstharz fließfähig und fließt in der Fäche nach außen über die Leiterplatten-Kontur hinaus und bildet dort nach dem Abkühlen und Erstarren einen undefinierten, mehr oder weniger breiten Rand. Häufig werden die Leiterplatten größer zugeschnitten als dem späteren Nutzformat entspricht, so daß der ausgeflossene Kunstharzrand zwischen dem überschüssigen Leiterplatten-Rand eingeschlossen bleibt.

Vor der Weiterbearbeitung muß dieser Rand bzw. der Kunstharz-Rand maßgenau abetrennt werden. Zugleich soll die nach dem Abtrennen des Randes entstandene Kante der zugeschnittenen Leiterplatten gratfrei sein und profiliert werden, um Fehler in der Weiterbearbeitung durch lose Partikel und scharfe Kanten zu vermeiden. Hierzu sind Verfahren bekannt, bei denen mittels Schlag- oder Rollscheren der Rand abgeschnitten wird. Ferner sind Fräsmaschinen bekannt, bei denen der Fräser entlang der feststehenden Leiterplatte fährt und die Kontur abfräst. Diese Verfahren haben den Nachteil, daß sie die Kante nicht nachbearbeiten. Je nach Verfahren werden die Leiterplatten außerdem hoch beansprucht; auch ist die Bearbeitungsgeschwindigkeit oft sehr gering und die bearbeitete Leiterplatten-Dicke begrenzt.

Eine weitere Vorrichtung nach der DE-OS 37 37 868 vermeidet diese Nachteile, jedoch können sich vorallem bei dünnen Leiterplatten durch die Form der Werkzeuge ungünstige Schwingungen ergeben, die die Qualität der bearbeiteten Leiterplatten-Kante nachteilig beeinflussen. Nach der DE-OS 30 20 292 ist eine Maschine bekannt für beidseitige Rillung zur späteren leichten Trennung durch Zerbrechen zu ermöglichen, was eine Nachbearbeitung der Kanten erfordert, die nicht gratfrei sind.

Durch die DE-A-2 159 427 ist eine Vorrichtung zur Bearbeitung von plattenförmigen Werkstücken bekannt. Die Vorrichtung weist zwei in einer Ebene einander gegenüberliegend angeordnete Kreissägeblätter, deren Sägezähne in einem geringen Abstand zueinander mit Spitze gegen Spitze angeordnet sind, ohne daß sie das Werkstück vollständig durchtrennen. An die Kreissägeblätter schließen sich unmittelbar eine in derselben Ebene angeordnete Trennscheibe, welche die vollständige Trennung des Werkstücks vom Rand bewirkt.

Nachteilig bei dieser Vorrichtung ist, daß nach der Trennung des Randes von der Platte eine Profilierung im zusätzlichen Arbeitsschritt nur möglich ist.

Der vorliegenden Erfindung liegt die Aufgabe zugrunde, die bekannte Vorrichtung so weiter zu entwickeln, daß mit dieser insbesondere dünne, aber auch mehrlagige Leiterplatten unterschiedlicher Formate maßgenau mit hoher Geschwindigkeit, geringer Belastung derselben bei Verwendung unterschiedlicher Positionierhilfen, gratfrei getrennt und besäumt werden können und im gleichen Arbeitsgang die Kanten profiliert werden.

Die Vorrichtung zum Trennen und Besäumen von Leiterplatten bzw. Leiterplattennutzen, insbes. von dünnen Leiterplatten sowie mehrlagigen Leiterplatten, weist zwei in einer Ebene einander gegenüberliegend angeordnete Kreissägeblätter, vorzugsweise mit Diamantschneiden, auf, deren Sägezähne zum nicht vollständigen Durchtrennen der Leiterplatte in einem geringen Abstand zueinander mit Spitze gegen Spitze angeordnet sind und synchron angetrieben werden, wobei zu diesen unmittelbar anschließend in derselben Ebene zur vollständigen Trennung der Leiterplatte vom Rand eine kreisförmige, axial angetriebene Trennscheibe angeordnet ist. Die Vorrichtung ist gekennzeichnet durch eine axial querverschiebbare Trennscheibe zum Erzeugen eines variablen Kantenprofils an der Leiterplatte. Der verbleibende "Reststeg" wird vorteilhafterweise möglichst dünn gewählt, jedoch ausreichend groß, damit die beiden Sägeblätter so einstellbar sind, daß ihre Zähne bei Einstellung Spitze gegen Spitze sich im Betrieb nicht berühren. Das vollständige Durchtrennen der Leiterplatte erfolgt in einem zweiten Bearbeitsschritt vorteilhafterweise mit einer dünnen Trennscheibe, die mit hoher Umfangsgeschwindigkeit umläuft und den Reststeg durchtrennt. Hierzu werden die Leiterplatten vorteilhafterweise horizontal auf einen Rundschalttisch mit auswechselbarer Aufspannplatte gelegt und dort mit Fangstiften bzw. dem bei der Herstellung der Leiterplatte verwendeten Positioniersystem fixiert. Die Aufspannplatte ist hierbei kleiner als das spätere Nutzformat der Leiterplatte, so daß der abzuschneidende Rand übersteht. Der Rundschalttisch ist einerseits auf einem Kreuztisch montiert, dessen beide Achse X, Y mittels Position und Geschwindigkeit regelbaren Motoren angetrieben werden, die hohe Verkehrsgeschwindigkeiten ermöglichen. Die aufgespannte Leiterplatte wird mit dem Kreuztisch positionsgenau an einem Sägen-Paar mit besonders profilierten Diamant-Schneiden vorbeigeführt, wobei zunächst eine Seite von oben und unten angekerbt und gleichzeitig profiliert wird, was durch die geeignete Ausbildung der Sägeschneide gewährleistet wird.

Möglichst unmittelbar anschließend wird der noch verbliebene Reststeg mit einer axial verstellbaren dünnen Trennscheibe vollständig durchgetrennt. Die Trennscheibe ist vorzugsweise mit Diamant-Teilen am Umfang besetzt und läuft mit hoher Geschwindigkeit um.

Nach dem Besäumen der ersten Kante wird die Leiterplatte mittels des Rundschalttisches um 90° gedreht und ein zweites Mal an dem Sägen-Paar und Trennscheibe vorbeigeführt. Dieser Vorgang wiederholt sich noch Zwei Mal, so daß die Leiterplatte am Ende der Bearbeitung an allen vier Kanten besäumt, entgratet und profiliert ist. Hierbei kann die Steuerung des Ablaufs mittels einer CNC-Steuerung erfolgen, die eine einfache Anpassung des Maschinenablaufs an das Leiterplattenformat zuläßt.

Eine bevorzugte Ausführungsform einer Vorrichtung gemäß der Erfindung ist beispielsweise in der Zeichnung dargestellt und zwar Zeigen:
- Figur 1: eine schematische Seitenansicht der gesamten Vorrichtung,
- Figur 2: einen Ausschnitt in der Draufsicht A bei Eingriff der Sägeblätter und der Trennscheibe,
- Figur 3: einen Längsschnitt beim Eingriff der beiden Sägeblätter,
- Figur 4: einen Querschnitt beim Eingriff der beiden Sägeblätter,
- Figur 5: einen Längsschnitt beim Eingriff der Trennscheibe,
- Figur 6: einen Querschnitt beim Eingriff der Trennscheibe.

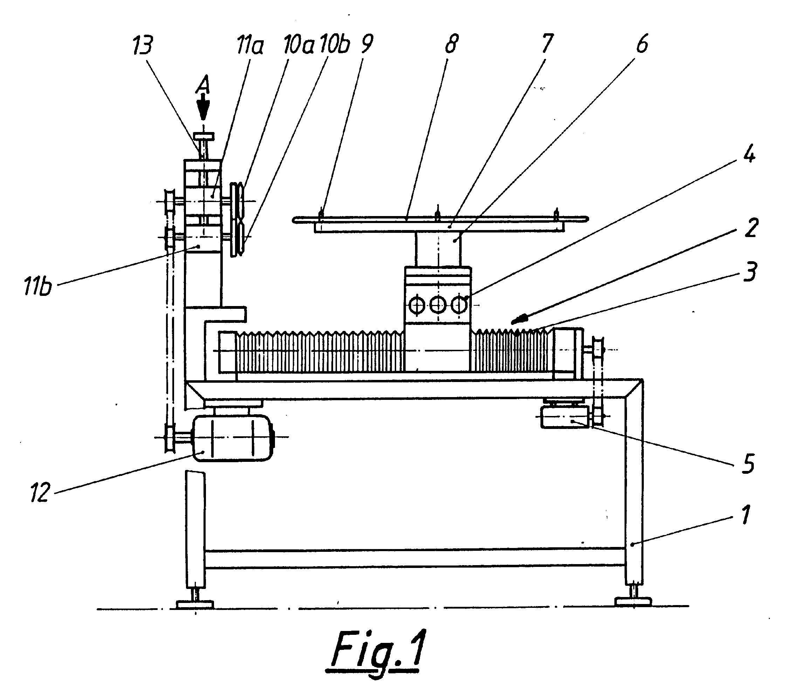

Wie aus der Zeichnung ersichtlich wird, ist nach Figur 1 auf dem Grundgestell 1 der Kreuztisch 2 aufgebaut mit den Achsen X-3 und Y-4. Der Antrieb 5 der X-Achse ist ebenfalls ersichtlich. Auf der Anschlußfläche der Y-Achse 4 ist der Rundschalttisch 6 angeordnet, auf welchem die Aufspannplatte 7 angeschraubt ist. Die Leiterplatte 8 liegt hierauf (7) und damit auf dem Rundschalttisch 6 und zwar mittels der Positionierhilfen 9 oder in einer anderen Ausführung mittels Vakuum in ihrer Lage fixiert. Die beiden Sägeblätter 10a und 10b sind in den Lagerböcken 11a und 11b gelagert und werden über einen gemeinsamen Zahnriemen oder in einer anderen Ausführung ein Getriebe, die beide Sägeblätterantriebe formschlüssig verbinden, vom Motor 12 angetrieben. Die Lagerböcke 11a und 11b können über die Verstellspindel 13 verstellt werden, um an unterschiedliche Sägeblätter und Leiterplattendicken angepaßt zu werden.

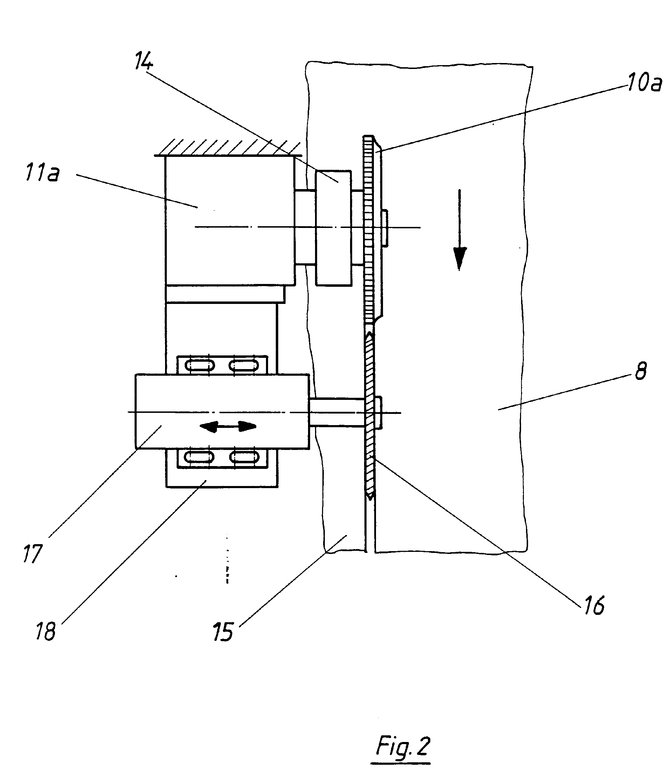

Nach Figur 2 mit Ansicht A als Ausschnitt auf die Vorrichtung, befindet sich die Leiterplatte 8 in der Arbeitsstation, d.h. beim Besäumen mit den Sägeblättern 10a und 10b. Die Leiterplatte 8 wird während des Sägens von zwei übereinanderliegenden Andruckrollen 14 zentriert. Das vollständige Abtrennen des Randes 15 erfolgt mit der Trennscheibe 16, die von einem Motor 17 angetrieben ist, der zum Leiterplatten-Durchgang querverschiebbar auf einer Konsole 18 montiert ist.
Nachdem der Rand vollständig abgetrennt ist, fällt er seitlich aus der Vorrichtung heraus.

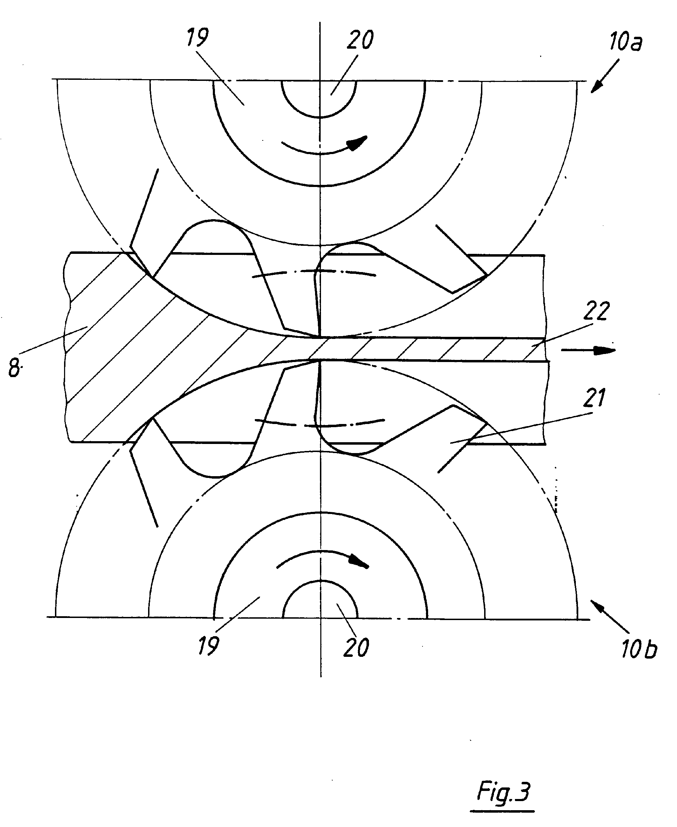

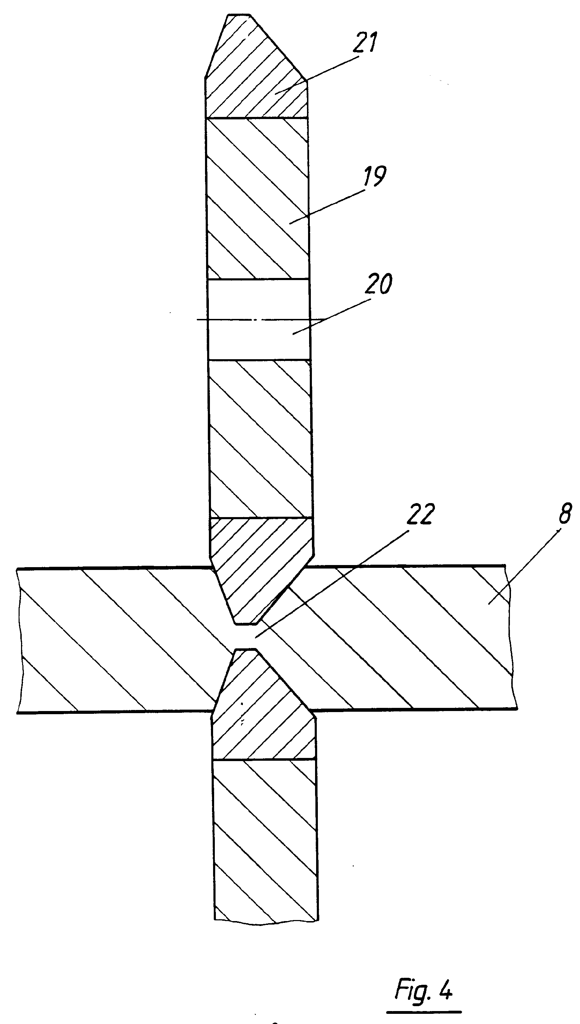

In Figur 3 ist verdeutlicht, wie die beiden Sägeblätter 10a und 10b in die Leiterplatte 8 eingreifen, wobei die über die Achsbohrungen 20 aufgenommenen Grundkörper 19 am Umfang mit mehreren Diamant-Schneidzähnen besetzt sind. Schneidzähne 21 sind so ausgebildet, daß sie die Leiterplatte 8 gleichzeitig einschneiden und profilieren, wie aus Fig. 4 ersichtlich, unter einem wählbaren Winkel W zur Sägeblatt-Mitte.

Aus Figur 3 und 4 wird außerdem die Anordnung der Sägeblätter mit Spitze gegenüber Spitze deutlich und die Ausbildung des Reststeges 22.

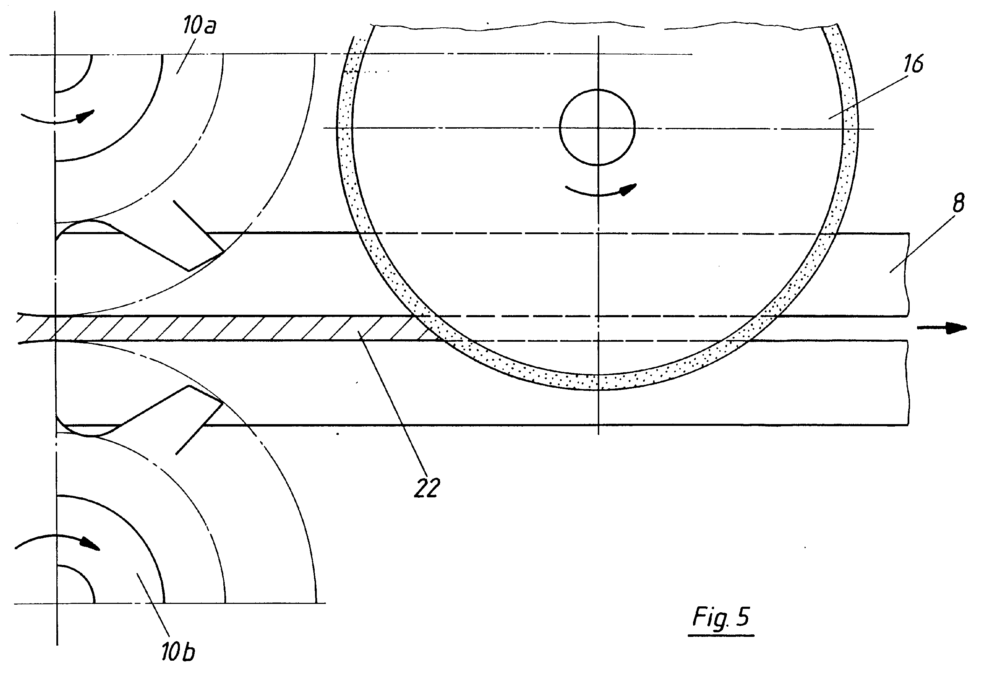

In Figur 5 ist die prinzipielle Anordnung der Trennscheibe 16 gegenüber den Sägeblättern 10a und 10b und der Leiterplatte 8 gezeigt. Wie ersichtlich, bleibt nach der Bearbeitung mit den beiden Sägeblättern ein Reststeg 22 stehen, der von der Trennscheibe 16 erst vollständig durchgetrennt wird.

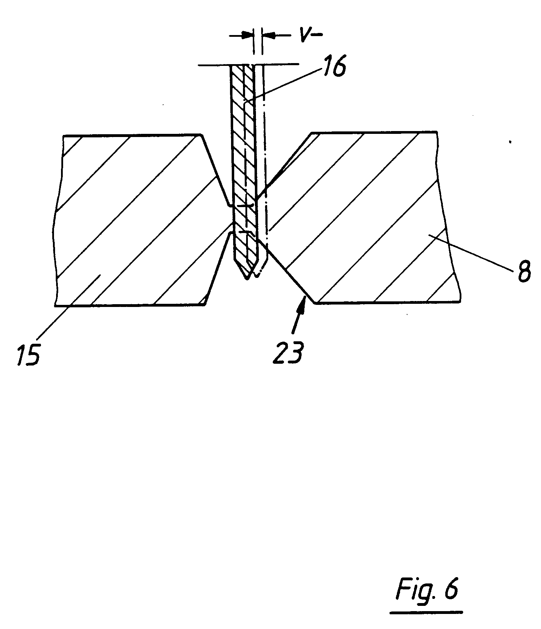

In Figur 6 ist schließlich im Querschnitt gezeigt, wie die Trennscheibe 16 in die Leiterplatte 8 eingreift, und wie das Profil der Kante 23 an der Leiterplatte nach vollständiger Bearbeitung aussieht. Hieraus ist außerdem ersichtlich, wie sich das Profil der Kante 23 verändert, wenn die Trennscheibe 16 um den Betrag V axial querverschoben wird.

## Patentansprüche

1. Vorrichtung zum Trennen und Besäumen von Leiterplatten bzw. Leiterplattennutzen, insbesondere von dünnen sowie mehrlagigen Leiterplatten, mit zwei in einer Ebene einander gegenüberliegend angeordneten Kreissägeblättern (10a,10b), vorzugsweise mit Diamantschneiden, wobei die Sägezähne (21) der Kreissägeblätter zum nicht vollständigen Durchtrennen der Leiterplatte (8) in einem geringen Abstand zueinander mit Spitze gegen Spitze angeordnet sind und synchron angetrieben werden und wobei zu diesen unmittelbar anschließend in derselben Ebene zur vollständigen Trennung der Leiterplatte (8) vom Rand (15) eine kreisförmige, axial angetriebene Trennscheibe (16) angeordnet ist, **dadurch gekennzeichnet,** daß die Trennscheibe (16) axial querverschiebbar ist zum Erzeugen eines variablen Kantenprofils an der Leiterplatte.

2. Vorrichtung nach Anspruch 1, **dadurch gekennzeichnet**, daß die axiale Verschiebung der Trennscheibe (16), d.h. quer zum Leiterplatten-Durchgang, manuell oder mittels eines Regelantriebes, z.B. CNC-gesteuert, erfolgt.

3. Vorrichtung nach Anspruch 1,
**dadurch gekennzeichnet,** daß die Sägeblätter bei sich nicht berührenden Sägezähnen mit variabler Eintauchtiefe angeordnet sind.

4. Vorrichtung nach Anspruch 1,
**dadurch gekennzeichnet,** daß die Verstellung der Sägeblätter zueinander über eine manuell betätigte oder eine mit einem Regelantrieb betätigte, z.B. CNC-gesteuerte Spindel erfolgt.

## Claims

1. Device for separating and trimming printed (circuit) boards and/or printed board panels, in particular thin and multilayer printed boards, with two rotary saw blades (10a, 10b) arranged opposite one another and in one plane, preferably with diamond cutters, whereby the saw teeth (21) of the rotary saw blades are arranged with little clearance between them with tip against tip, for incomplete cutting through the printed board (8), and are driven synchronously, and whereby a circular, axially driven cutting disc (16) is arranged in the same plane directly adjoining it, for complete cut off of the printed board (8) from the edge (15), characterized in that the cutting disc (16) is transversely movable along the axis to achieve a varied cant profile on the printed board.

2. Device in accordance with Claim 1, characterized in that the axial movement of the cutting disc (16), i.e. transversely to the printed board passage, takes place manually or by means of a variable speed drive, e.g. CNC controlled.

3. Device in accordance with Claim 1, characterized in that the saw blades are arranged with variable contact depth with the saw teeth not being in contact with one another.

4. Device in accordance with Claim 1, characterized in that the adjustment of the saw blades relative to each other is by means of a spindle operated manually or by means of a variable speed drive (e.g. CNC controlled).

## Revendications

1. Dispositif de séparation et de bordure de plaques de circuits imprimés ou de flans de plaques de circuits imprimés, et plus particulièrement de plaques de circuits imprimés minces ou multicouches, comprenant deux lames (10a,10b) de scies circulaires se faisant face dans un même plan, de préférence avec un tranchant diamanté, les dents (21) desdites lames (10a,10b) étant disposées pointe contre pointe, séparées par un faible écartement permettant de ne pas trancher complètement la plaque (8) de circuits imprimés, lesdites lames (10a,10b) étant entraînées en synchronisation, et comprenant, disposé immédiatement après lesdites lames (10a,10b) et dans le même plan, un disque à trancher (16) circulaire et entraîné selon son axe, assurant la séparation complète de la plaque (8) de circuits imprimés d'avec le bord (15), caractérisé en ce que le disque à trancher (16) est mobile dans la direction de son axe afin de créer, sur la plaque (8) de circuits imprimés, des bords à profil variable.

2. Dispositif selon la revendication 1, caractérisé en ce que le déplacement axial du disque à trancher (16), c'est-à-dire transversalement au passage de la plaque (8) de circuits imprimés, est réalisé manuellement ou au moyen d'un entraînement doté d'une régulation, par exemple d'une commande numérique à calculateur.

3. Dispositif selon la revendication 1, caractérisé en ce que la profondeur d'attaque des dents (21) des lames (10a,10b) de scies est variable, sans que lesdites dents (21) puissent se toucher.

4. Dispositif selon la revendication 1, caractérisé en ce que le réglage des lames (10a,10d) de scies l'une par rapport l'autre est réalisé au moyen d'un arbre actionné manuellement ou, par exemple au moyen d'un arbre actionné par une commande numérique à calculateur.
